# EUROPÄISCHE PATENTSCHRIFT

(11) **EP 3 650 878 B1**
(45) Veröffentlichungstag und Bekanntmachung des Hinweises auf die Patenterteilung: **12.02.2025**
(21) Anmeldenummer: 18205132.6
(22) Anmeldetag: 08.11.2018
(51) Int. Cl.: G01R 33/341, G01R 33/36, G01R 33/567, G01R 33/565

(54) **LOKALSPULE MIT PILOTTON-SENDER**
LOCAL COIL WITH PILOT TONE TRANSMITTER
BOBINE LOCALE AVEC TRANSMETTEUR DE TONALITÉ PILOTE

(43) Veröffentlichungstag der Anmeldung: 13.05.2020
(73) Patentinhaber: Siemens Healthineers AG, 91301 Forchheim (DE)
(72) Erfinder: Dornberger, Barbara, 91052 Erlangen (DE); Rehner, Robert, 91077 Neunkirchen am Brand (DE)
(74) Vertreter: Siemens Healthineers Patent Attorneys

(56) Entgegenhaltungen:
- WO-A1-2014/096997
- US-A- 6 008 649
- US-A1- 2014 239 953
- PISA STEFANO ET AL: "A survey of radar systems for medical applications", IEEE AEROSPACE AND ELECTRONIC SYSTEMS MAGAZINE, IEEE SERVICE CENTER, PISCATAWAY, NJ, US, vol. 31, no. 11, 1 November 2016 (2016-11-01), pages 64 - 81, XP011635899, ISSN: 0885-8985, [retrieved on 20161205], DOI: 10.1109/MAES.2016.140167
- THIEL F ET AL: "Non-contact detection of myocardium's mechanical activity by ultrawideband RF-radar and interpretation applying electrocardiography", REVIEW OF SCIENTIFIC INSTRUMENTS, AIP, MELVILLE, NY, US, vol. 80, no. 11, 10 November 2009 (2009-11-10), pages 114302 - 114302, XP012127988, ISSN: 0034-6748, DOI: 10.1063/1.3238506

## Beschreibung

Die Erfindung betrifft eine Lokalspule für einen Magnetresonanztomographen mit einem Sender zur Erzeugung des Pilottons, eine Sendeantenne zur Abstrahlung des Pilottons und eine Empfangsantenne zum Empfang des Pilottons.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt.

Die Bilderfassung bei einer Magnetresonanztomographie erfordert je nach verwendeter Pulsfolge, auch als Sequenz bezeichnet, etliche Millisekunden bis zu Sekunden, wobei üblicherweise eine längere Erfassungszeit zu geringen Rauschartefakten führt. Es ist daher sinnvoll, die Bilderfassung jeweils zu Beginn einer Phase zu starten, in der der Körper verhältnismäßig unbewegt bleibt, um Bewegungsartefakte durch eine Bewegung während der Bilderfassung zu vermeiden. Nicht vermeidbare Bewegungen sind zum Beispiel die Atmung und der Herzschlag. Jedoch folgt hier auf eine Phase mit Bewegungen auch eine Phase relativer Ruhe, zum Beispiel nach dem Ausatmen oder einer Kontraktion des Herzmuskels. Eine Bilderfassung in dieser Phase hat einen relativ langen Zeitraum mit wenigen Bewegungen zu erwarten, sodass hier die besten Messergebnisse zu erwarten sind.

Dabei ist es grundsätzlich schon bekannt, die Bewegungen beispielsweise mittels mechanischer Sensoren oder durch Elektroden zu erfassen, die die Anregungspotentiale der Muskeln messen.

Die Druckschrift DE 10 2015 203 385 beschreibt ein grundsätzliches Verfahren, mittels eines Hochfrequenzsignals die Bewegungen zu erfassen. Dabei wird das Signal in einer Patientenaufnahme eines Magnetresonanztomographen permanent erfasst und Signalveränderungen durch Bewegungen, beispielsweise durch sich ändernde Interferenzen oder Dämpfung ausgewertet. Aus bestimmten Mustern dieses Signals kann dann eine Bewegung des Patienten, verursacht durch Atmung oder Herzschlag, erkannt werden.

Aus der Druckschrift WO 2015/150953 A1 ist ein Sender zum Aussenden eines Synchronisationssignals bekannt, dessen zwei Antennen an den Enden einer Patientendurchführung angeordnet sind. Als Synchronisationssignal kann dabei auch ein Pilotton ausgesendet werden.

Die Druckschrift DE 10 2015 224 158 beschreibt einen Sender zur Pilotton-Navigation bei einem Magnetresonanztomographen sowie ein Verfahren zur Erkennung einer Bewegung eines Patienten bekannt. Der Sender weist eine Energieversorgung und eine Antenne auf. Der Sender ist ausgelegt, über die Antenne ein Pilotton-Signal auszusenden. Der Sender weist weiterhin ein Entkopplungselement auf, um den Senderausgang vor Signalen zu schützen, die die Antenne bei Anregungspulsen des Magnetresonanztomographen während einer Magnetresonanztomographie empfängt. In dem Verfahren werden bewegungsabhängige Veränderungen des Pilotton-Signals des Senders von einer Steuerung des Magnetresonanztomographen erkannt.

Aus dem Dokument "PISA STEFANO ET AL: "A survey of radar systems for medical applications", IEEE AEROSPACE AND ELECTRONIC SYSTEMS MAGAZINE, IEEE SERVICE CENTER, PISCATAWAY, NJ, US, Bd. 31, Nr. 11" ist eine Übersicht von Radar-Systemen für medizinische Anwendungen bekannt, darunter auch die Überwachung von Herz- und Atemtätigkeit. Beschrieben werden auch Antennen, unter anderem auch planare Antennen.

Das Dokument "THIEL F ET AL: "Non-contact detection of myocardium's mechanical activity by ultrawideband RF-radar and interpretation applying electrocardiography", REVIEW OF SCIENTIFIC INSTRUMENTS, AIP, MELVILLE, NY, US, Bd. 80, Nr. 11" beschreibt die synergetische Nutzung von Breitband-Radar in Verbindung mit Magnetresonanztomographie um ergänzende Information zur Verbesserung von Diagnose und Abbildung bereitzustellen, insbesondere bei Herz-Magnetresonanztomographie als berührungsfreier Sensor der Herzkontraktion.

Aus dem Dokument US 2014/0239953 A1 ist eine Vielkanal-Antenne für einen Magnetresonanztomographen bekannt, die eine erste resonante Antennenschleife mit einem Sendeelement aufweist und eine zweite resonante Antennenschleife mit einem Sendeelement, wobei die zweite resonante Antennenschleife neben der ersten resonanten Antennenschleife angeordnet ist.

Aus dem Dokument WO 2014/096997 Al ist ein Entkopplungsschaltkreis bekannt, der zwischen zwei benachbarten Hochfrequenz-Empfangsspulen angeordnet ist, um diese Empfangsspulen automatisch zu entkoppeln. In einer Ausführungsform schlägt das Dokument vor, ein Testsignal in die erste Empfangsspule einzukoppeln, um die Kopplung der ersten Empfangsspule zu der zweiten Empfangsspule messen zu können.

Das Dokument US 6008649 A beschreibt eine Lokalspulenvorrichtung für ein Magnetresonanzsystem.

Die Lokalspule weist eine Spulenanordnung mit einem Paar länglicher Spulen auf, die parallel zueinander und in einem Abstand angeordnet sind, und eine vorbestimmte Zahl lateraler Spulen, die entlang der länglichen Spulen parallel zueinander mit Abstand untereinander angeordnet sind. Erste Kapazitäten sind entlang der länglichen Spulen positioniert und eine zweite Kapazität ist jeweils in die lateralen Spulen integriert. Mit einem ersten Koppelnetzwerk wird die Spulenanordnung in einem ersten Modus betrieben, um ein B1-Magnetfeld mit einer ersten Frequenz zu empfangen, die durch die ersten und die zweiten Kapazitäten bestimmt wird. In gleicher Weise wird die Antennenanordnung über ein zweites Koppelnetzwerk in einem zweiten Modus mit einer zweiten Frequenz betrieben.

Es stellt sich daher die Aufgabe, die Anwendung eines Pilotton-Signals zu vereinfachen.

Die Aufgabe wird durch eine erfindungsgemäße Lokalspule nach Anspruch 1 gelöst.

Die erfindungsgemäße Lokalspule weist eine Sendeantenne zum Aussenden eines Pilottons auf. Die Sendeantenne kann beispielsweise eine magnetische Antenne in Form einer Spule oder Schleife sein, denkbar ist aber auch eine elektrische Antenne wie ein Dipol, je nach Wellenlänge des Pilotton-Signals. Der Pilotton kann von einem Magnetresonanztomographen über eine Signalverbindung zugeführt werden, es ist aber auch denkbar, dass die Lokalspule einen Sender zur Erzeugung eines Pilottons und eine Sendeantenne zur Abstrahlung des Pilottons aufweist. Der Sender kann dabei beispielsweise ein Oszillator oder anderer Signalerzeuger sein, der ein Signal mit einer vorbestimmten Frequenz erzeugen kann. Denkbar ist auch ein Verstärker oder Mischer, der das Pilotton-Signal aus einem von dem Magnetresonanztomographen zugeführten Signal erzeugt oder ableitet.

Weiterhin weist die Lokalspule eine Empfangsantenne zum Empfang des Pilottons auf. Die Empfangsantenne kann dabei beispielsweise eine Antennenspule sein, die auch zum Empfang von MR-Signalen in der Lokalspule vorgesehen ist. Dabei ist es denkbar, dass das Pilotton-Signal im gleichen Frequenzbereich wie das MR-Signal liegt oder die Empfangsantenne auf mehreren Frequenzen, die des Pilotton-Signals und die des MR-Signals abgestimmt ist. Denkbar ist aber auch, dass eine separate Empfangsantenne für das Pilotton-Signal vorgesehen ist. Schließlich weist die erfindungsgemäße Lokalspule eine Entkopplungsvorrichtung zum Entkoppeln der Empfangsantenne von der Sendeantenne auf. Als Entkoppeln wird dabei eine Verringerung des durch die Empfangsantenne direkt, d.h. ohne Wechselwirkung mit der Umgebung, insbesondere dem Patienten, beispielsweise im freien Raum, empfangenen Pilotton-Signals um beispielsweise 3 dB, 6 dB, 12 dB oder mehr im Vergleich zu einer Lokalspule ohne Entkopplungsvorrichtung angesehen. Verschiedene Ausführungsformen einer Entkopplungsvorrichtung sind nachfolgend in den Unteransprüchen angegeben.

Die Entkopplungsvorrichtung der erfindungsgemäßen Lokalspule ist ausgelegt, die Sendeantenne induktiv von der Empfangsantenne zu entkoppeln. Erfindungsgemäß kann bei einer magnetischen Empfangs- und Sendeantenne eine induktive Entkopplung wie nachfolgend angegeben durch geometrische Überlappung erfolgen. In nicht beanspruchten Ausführungsformen ist es aber auch denkbar, dass zusätzliche Induktivitäten bzw. Hochfrequenztransformatoren für eine Entkopplung sorgen.

Die Empfangsantenne der erfindungsgemäßen Lokalspule weist eine erste Antennenspule und die Entkopplungsvorrichtung eine erste Induktionsschleife auf.

Als Antennenspule wird dabei eine magnetische Antenne bezeichnet, deren Wirkung auf der Induktion der magnetischen Komponente eines elektromagnetischen Wechselfeldes beruht. Der elektrische Leiter der Antennenspule umschließt dazu eine Fläche, in deren Inneren durch einen durch den Leiter fließenden Strom ein Magnetfeld induziert wird. Die umschlossene Fläche ist dabei vorzugsweise im Wesentlichen eben, d.h. Abweichungen der umschlossenen Fläche senkrecht zu einer durch die Fläche gelegten Ebene betragen weniger als 30%, 20% oder 10% einer maximalen Abmessung der umschlossenen Fläche parallel zu der Ebene. Die Antennenspule kann eine oder mehrere Windungen aufweisen. Eine Induktionsschleife ist im Sinne der Erfindung ebenfalls eine von einem Leiter zumindest teilweise umschlossene ebene Fläche. Es ist aber denkbar, dass die Induktionsschleife nicht ganz geschlossen ist, beispielsweise der Leiter nicht in unmittelbarer Nähe zueinander zu der Induktionsschleife zugeführt bzw. abgeführt wird. Die Induktionsschleife kann also beispielsweise auch U-förmig ausgeführt sein. Der Leiter kann auch kapazitive und/oder induktive Elemente aufweisen, im allgemeinen Sinn also ein Leiter mit komplexer Impedanz sein.

Dabei weist eine Projektion einer von der ersten Induktionsschleife umschlossenen Fläche auf eine von der ersten Antennenspule umschlossene Fläche entlang einer Flächennormale der umschlossenen Fläche eine nichtleere Schnittmenge auf. Als Flächennormale wird hierbei beispielsweise die Flächennormale der zuvor beschriebenen Ebenen durch die Flächen angesehen.

Mit anderen Worten, die Antennenspule und die Induktionsschleife überlappen, sodass ein durch die Induktionsschleife fließender Strom ein Magnetfeld erzeugt, das durch die Antennenspule verläuft und dort wiederum einen Strom induziert.

Die erfindungsgemäße Lokalspule vereinfacht durch die Integration von Sendeantenne und Empfangsantenne die Anwendung des Pilottons. Auf vorteilhafte Weise reduziert die Lokalspule mit Entkopplungsvorrichtung dabei Anteile des Pilotton-Signals, die ohne Wechselwirkung mit dem Patienten empfangen werden und die damit auch keine Information zu beispielsweise Herzschlag oder Atmung enthalten. Ohne diese direkten Signalanteile erhöht sich der Modulationsgrad des empfangenen Pilottonsignals und der Signal-zu-Rauschabstand sowie die Erkennung der physiologischen Vorgänge verbessern sich. Auf vorteilhafte Weise kann eine induktive Entkopplung ohne galvanische Kontakte zwischen Pilotton-Sender und Empfangsantenne eine Entkopplung erzielen und so zusätzliche Störeinkopplungen und Dämpfungen vermeiden.

Auf vorteilhafte Weise kann durch einen Überlapp der Flächen von Induktionsschleife und Antennenspule eine gezielte Wechselwirkung erreicht werden, die über die Fläche des Überlappens, d.h. der Fläche der Schnittmenge eingestellt werden kann. Je nach Stromrichtung kann dabei die Polarität des Magnetfeldes und damit auch die Polarität des induzierten Stromes verändert werden.

Bei der erfindungsgemäßen Lokalspule weist die Entkopplungsvorrichtung eine zweite Induktionsschleife auf, die im Wesentlichen parallel zur ersten Induktionsschleife ausgerichtet ist. Im Wesentlichen parallel ist dabei darunter zu verstehen, dass die Flächennormalen der ersten Induktionsschleife und der zweiten Induktionsschleife einen Winkel kleiner als 45 Grad, 30 Grad oder 10 Grad einschließen. Dabei ist die Entkopplungsvorrichtung ausgelegt, bei Aussenden des Pilottons jeweils ein Magnetfeld in der ersten Induktionsschleife und der zweiten Induktionsschleife zu erzeugen, deren Magnetfeldkomponenten in Richtung der Flächennormalen der von der ersten Induktionsschleife und/oder zweiten Induktionsschleife umschlossenen Fläche gleiche Vorzeichen aufweisen. Mit anderen Worten, das von der ersten Induktionsschleife und der zweiten Induktionsschleife erzeugte Magnetfeld ist im Wesentlichen in die gleiche Richtung ausgerichtet. Dies kann erreicht werden, indem der gleiche Strom die erste Induktionsschleife und die zweite Induktionsschleife in gleichem Umlaufsinn durchfließt, beispielsweise beide im Uhrzeigersinn oder beide gegen den Uhrzeigersinn.

Dabei weist eine Projektion der von der zweiten Induktionsschleife umschlossenen Fläche auf eine von der ersten Antennenspule umschlossene Fläche entlang einer Flächennormale der umschlossenen Fläche eine leere Schnittmenge auf.

Bezüglich der Flächen und deren Flächennormale gilt das bereits ausgeführte. Mit anderen Worten, die Fläche der ersten Antennenspule und der zweiten Induktionsschleife überlappen nicht, sondern sind disjunkt. Dadurch ist die zweite Induktionsschleife bezüglich der ersten Antennenspule so angeordnet, dass die von der ersten Antennenspule umschlossene Fläche außerhalb der von der zweiten Induktionsschleife umschlossenen Fläche liegt. Wenn wie zuvor angegeben, das innerhalb der Induktionsschleifen erzeugte Magnetfeld gleiches Vorzeichen aufweist, so hat das Magnetfeld im Außenbereich der Induktionsschleife gerade umgekehrtes Vorzeichen. Die Wirkung der ersten Induktionsschleife und der zweiten Induktionsschleife auf die erste Antennenspule reduzieren sich so gegenseitig. Bei geeigneter Dimensionierung der ersten Induktionsschleife und der zweiten Induktionsschleife und geeigneter Positionierung relativ zu der ersten Antennenschleife ist es sogar möglich, dass sich die Wirkung aufhebt.

Eine Sendeantenne bestehend aus erster Induktionsschleife und zweiter Induktionsschleife ist dann im Sinne der Erfindung auf vorteilhafte Weise durch die Entkopplungsvorrichtung von der Empfangsspule entkoppelt.

Weitere vorteilhafte Ausführungsformen sind in den Unteransprüchen angegeben.

In einer denkbaren Ausführungsform der erfindungsgemäßen Lokalspule weist die Lokalspule eine zweite Antennenspule auf. Dabei ist die Schnittmenge einer Projektion der von der ersten Induktionsschleife umschlossenen Fläche auf eine von der zweiten Antennenspule umschlossene Fläche entlang einer Flächennormale der umschlossenen Fläche eine leere Schnittmenge. Dabei gilt zu den Flächen und Flächennormalen das bisher gesagte. Mit anderen Worten, die erste Induktionsschleife und die zweite Antennenspule sind disjunkt und weisen keine überlappenden Flächen auf. Weiterhin weist eine Projektion der von der zweiten Induktionsschleife umschlossenen Fläche auf eine von der zweiten Antennenspule umschlossene Fläche entlang einer Flächennormale der umschlossenen Fläche eine nichtleere Schnittmenge auf. Mit anderen Worten, die zweite Induktionsschleife und die zweite Antennenspule überlappen, wie es auch die erste Induktionsschleife und die erste Antennenspule tun.

Wie bereits dargelegt, wirkt so vorteilhafter Weise die erste Induktionsschleife zur Entkopplung für die zweite Induktionsschleife zu der zweiten Antennenspule, wie es auch die zweite Induktionsschleife für die erste Antennenspule bewirkt. Gleichzeitig wirken aber die erste Induktionsschleife und die zweite Induktionsschleife wegen der gleichgerichteten Magnetfelder als Sendeantenne für das Pilotton-Signal.

In einer möglichen Ausführungsform der erfindungsgemäßen Lokalspule weist eine Projektion der von der ersten Antennenspule umschlossenen Fläche entlang der Flächennormale auf die von der zweiten Antennenspule umschlossene Fläche eine nichtleere Schnittmenge auf. Mit anderen Worten, die erste Antennenspule und die zweite Antennenspule überlappen. Dabei ist es denkbar, dass die überlappende Fläche einen Anteil von weniger als 50%, 30%, 20% oder 10% der von der ersten bzw. zweiten Antennenspule umschlossenen Fläche einnimmt.

Auf vorteilhafte Weise wirkt die überlappende Fläche auf die gleiche zu den Induktionsschleifen beschriebene Weise als induktive Entkopplung zwischen der ersten Antennenspule und der zweiten Antennenspule.

In einer denkbaren Ausführungsform der erfindungsgemäßen Lokalspule weist die erste Induktionsschleife einen Überbrückungsleiter auf. Der Überbrückungsleiter verbindet zwei Punkte am Umfang der ersten Induktionsschleife elektrisch miteinander. Dabei ist es auch denkbar, dass der Überbrückungsleiter Elemente mit einem komplexen Widerstand, beispielsweise eine Kapazität aufweist. Der Überbrückungsleiter teilt auf diese Weise die Induktionsschleife in zwei disjunkte Flächen bzw. Bereiche auf. Die beiden Bereiche können gleichen Flächeninhalt aufweisen, es ist aber auch denkbar, dass sich die Flächen im Verhältnis unterscheiden, beispielsweise 40:60 oder 30:70.

In einer möglichen Ausführungsform weist dabei der Überbrückungsleiter eine veränderbare Kapazität auf. Die Kapazität kann beispielsweise ein Trimmkondensator sein, mit dem identische Sendespulen in Lokalspulen mit unterschiedlichen Geometrien eingesetzt und angepasst werden können.

Denkbar sind aber auch von dem Magnetresonanztomographen durch eine Spannung oder ein Kontrollsignal und eine Steuereinrichtung veränderbare Kapazitäten, beispielsweise PIN-Dioden oder auch schaltbare Kapazitäten mit MEMS-Schaltern.

Auf vorteilhafte Weise ermöglicht die veränderbare Kapazität eine effektive Fläche und damit eine induktive Kopplung der Induktionsschleife mit den Antennenspulen zu verändern. Auf vorteilhafte Weise kann so die Entkopplung der Sendeantenne von der Empfangsantenne durch den Magnetresonanztomographen an unterschiedliche Bedingungen, beispielsweise durch die Wechselwirkung mit dem Körper des Patienten oder eine unterschiedliche Geometrie bei einer flexiblen Lokalspule angepasst werden und immer eine maximale Sensitivität für das aus dem Körper des Patienten kommende Pilotton-Signal erzielt werden.

In einer nicht beanspruchten Ausführungsform der erfindungsgemäßen Lokalspule weist die Entkopplungsvorrichtung ein kapazitives Entkopplungsnetzwerk mit einer Kapazität auf, die die Sendeantenne mit der Empfangsantenne elektrisch verbindet. Möglich sind beispielsweise eine oder vorzugsweise zwei Kapazitäten, die jeweils eine Anzapfung der Sendeantenne, z.B. an der ersten Induktionsschleife, mit einer Anzapfung an der Empfangsantenne, z.B. an der Antennenspule, elektrisch verbindet.

In einer denkbaren Ausführungsform des erfindungsgemäßen Magnetresonanztomographen weist der Magnetresonanztomograph eine erfindungsgemäße Lokalspule auf. Der Magnetresonanztomograph ist dabei ausgelegt, ein Pilotton-Signal, beispielsweise in einer Hochfrequenzeinheit bereitzustellen, über eine Signalverbindung an die Lokalspule zu übertragen und über die Sendeantenne der Lokalspule auszusenden.

Auf vorteilhafte Weise ist der Magnetresonanztomograph in der Lage, Signale mit hochgenauen und stabilen Frequenzen bereitzustellen, sodass auf vorteilhafte Weise verhindert werden kann, dass das Pilotton-Signal eine Bilderfassung mittels Magnetresonanz stört. Beispielsweis können Frequenzen gewählt werden, die gerade außerhalb eines Frequenzbereichs des Magnetresonanzsignals liegen, beispielsweise um weniger als 100 kHz, 500 kHz oder 1 MHz, sodass vorteilhafter Weise die Antennen für das MR-Signal noch ausreichend Empfindlichkeit zum Empfang aufweisen und genutzt werden können, aber durch die genaue Einhaltung des Frequenzabstandes eine Störung vermieden wird.

In einer denkbaren Ausführungsform des erfindungsgemäßen Magnetresonanztomographen weist der Magnetresonanztomograph eine Lokalspule mit einer veränderbaren Kapazität in der ersten Induktionsschleife auf. Der Magnetresonanztomograph weist weiterhin eine Steuereinheit auf, die ausgelegt ist, die veränderbare Kapazität derart einzustellen, dass die Empfangsantenne von der Sendeantenne optimal entkoppelt ist. Als optimal entkoppelt ist beispielsweise anzusehen, dass das Signal-zu-Rausch-Verhältnis des empfangenen Pilotton-Signals mit einer physiologischen Information ein lokales Maximum aufweist. Die Steuereinheit kann dieses lokale Maximum beispielsweise durch ein numerisches Gradienten-Optimierungsverfahren oder anderes Optimierungsverfahren unter Variation der veränderbaren Kapazität erreichen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines Magnetresonanztomographen mit einer erfindungsgemäßen Lokalspule;
- Fig. 2: eine schematische Darstellung einer erfindungsgemäßen Lokalspule;
- Fig. 3: eine schematische Darstellung einer erfindungsgemäßen Lokalspule;
- Fig. 4: eine schematische Darstellung einer Induktionsschleife einer Ausführungsform einer erfindungsgemäßen Lokalspule;
- Fig. 5: eine schematische Darstellung eines kapazitiven Entkopplungsnetzwerkes einer erfindungsgemäßen Lokalspule.

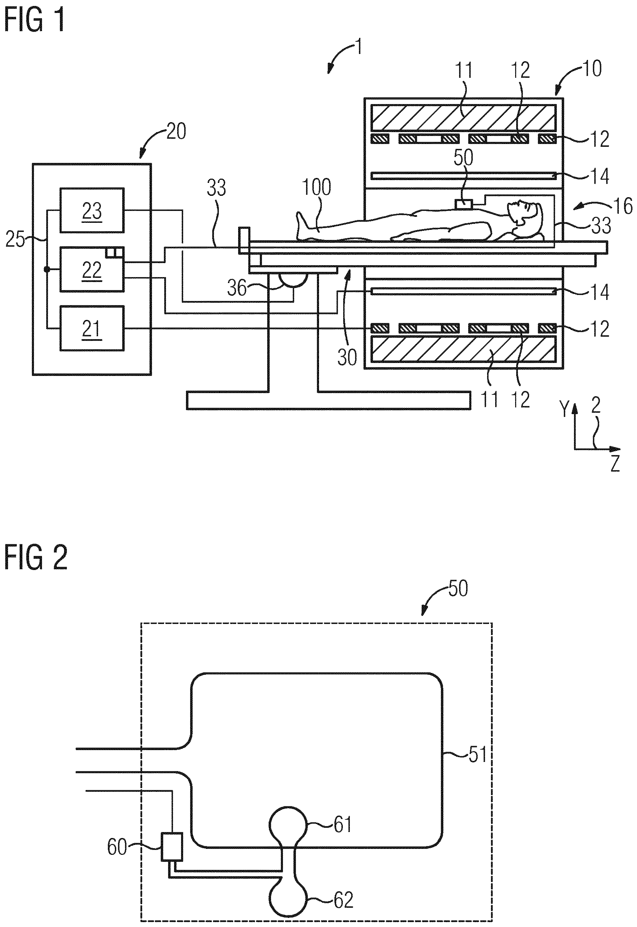

Fig. 1 zeigt eine schematische Darstellung einer Ausführungsform eines Magnetresonanztomographen 1 mit einer erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine Anschlussleitung 33 mit der Hochfrequenzeinheit 22 und deren Empfänger verbunden ist.

In Fig. 2 ist eine Ausführungsform einer erfindungsgemäßen Lokalspule 50 dargestellt. Die Lokalspule weist als Empfangsantenne für MRT-Signale eine erste Antennenspule 51 auf. Beispielhaft ist hier eine Leiterschleife mit einer einzelnen Windung dargestellt, es sind aber auch Antennenspulen mit mehreren Windungen denkbar. Denkbar sind auch zusätzliche Kapazitäten in der Antennenspule zum Abstimmen im Empfangsfall bzw. Verstimmen während eines Anregungspulses. Aus Gründen der Übersicht sind weitere Elemente zur Verarbeitung der empfangenen Signale in der Lokalspule nicht dargestellt, wie beispielsweise rauscharme Vorverstärker, Oszillator und Mischer zur Frequenzumsetzung oder Analog-Digitalwandler zur Digitalisierung.

Die Lokalspule 50 weist in einer möglichen Ausführungsform weiterhin einen Pilottonsender 60 auf, der ein Pilotton-Signal erzeugt. Der Pilotton-Sender 60 ist elektrisch mit einer Sendeantenne verbunden, die eine erste Induktionsschleife 61 und eine zweite Induktionsschleife 62 aufweist. Dabei befindet sich die erste Induktionsschleife 61 innerhalb einer von der ersten Antennenschleife 51 umschlossenen Fläche, während sich die zweite Induktionsschleife 62 außerhalb dieser umschlossenen Fläche befindet. Dabei kann es auch sein, dass sich die erste Induktionsschleife 61 in Richtung einer Flächennormale der umschlossenen Fläche beabstandet, d.h. über oder unter der Antennenschleife befindet. Vorzugsweise ist dabei der Abstand kleiner als eine laterale Abmessung der Induktionsschleife, z.B. der Durchmesser der Induktionsschleife.

In einer anderen Ausführungsform ist es auch denkbar, dass das Pilotton-Signal in dem Magnetresonanztomographen 1, beispielsweise in der Hochfrequenzeinheit 22, bereitgestellt wird und der Lokalspule 50 über die Anschlussleitung 33 der Lokalspule zugeführt wird. Auch sind Mischformen denkbar, beispielsweise dass der Magnetresonanztomograph ein Signal zuliefert, aus dem das Pilotton-Signal durch Verstärkung, Frequenzumsetzung und/oder Modulation erzeugt wird. Dadurch kann insbesondere eine hochgenaue und stabile Frequenz gewährleistet werden, die die eigentliche Magnetresonanz-Bilderfassung nicht stört.

Die erste Antennenspule 51, die erste Induktionsschleife 61 und die zweite Induktionsschleife 62 sind dabei im Wesentlichen parallel ausgerichtet, d.h. eine Ebene durch die erste Antennenspule 51 und eine Ebene durch die erste Induktionsspule 61 bzw. die zweite Induktionsschleife 62 schließen einen Winkel ein, der kleiner als 45 Grad, 30 Grad oder 10 Grad ist.

Ein Strom, der von dem Pilottonsender 60 erzeugt und der Sendeantenne zugeführt wird, durchfließt die erste Induktionsschleife 61 und die zweite Induktionsschleife 62 im gleichen Drehsinn, sodass er im Inneren der von den Induktionsschleifen 61, 62 umschlossenen Flächen ein Magnetfeld erzeugt, dass im Wesentlichen parallel zueinander bzw. gleich gerichtet ist. Außerhalb der von den Induktionsschleifen 61, 62 umschlossenen Flächen ändert die Magnetfeldkomponente in Richtung der Flächennormalen der von den Induktionsschleifen umschlossenen Flächen ihr Vorzeichen. Für die erste Induktionsschleife 61 in Fig. 2 verläuft ein Teil der von ihr erzeugten Magnetfeldlinien auch außerhalb der ersten Antennenschleife 51. Das von der ersten Induktionsschleife 61 erzeugte Feld im Inneren der von der ersten Induktionsschleife 61 umschlossenen Fläche wird dabei von dem im Außenraum der ersten Induktionsschleife 61 erzeugten Feld in Bezug auf einen in der ersten Antennenschleife 51 induzierten Strom nur teilweise kompensiert.

Erst durch die zweite Induktionsschleife 62 sowie eine geeignete Dimensionierung der Flächen und lateralen Abstände lässt sich eine Kompensation erreichen und die Kopplung zwischen der Sendeantenne und der ersten Antennenspule 51 reduzieren bzw. ganz eliminieren.

Das Pilotton-Signal kann der Sendeantenne bzw. der Induktionsschleife direkt über Anschlüsse, wie in Fig. 2 bis 5 angedeutet, zugeführt werden und zu einem Stromfluss in der induktionsschleife führen. Es ist aber beispielsweise auch möglich, einen Stromfluss in der Induktionsschleife durch induktive Einkopplung zu erzielen, wie es bei magnetischen Antennen oft üblich ist. Auch sind andere Anpassungsnetzwerke mit induktiven und/oder kapazitiven Elementen denkbar. Gleiches gilt für das Auskoppeln eines empfangenen Pilotton-Signals aus den Empfangsantennen.

Grundsätzlich wäre es aber auch denkbar, dass die erste Induktionsschleife 61 und die zweite Induktionsschleife 62 zusammen eine Spule mit beispielsweise einer Windung und durchgehender umschlossener Fläche bilden, die teilweise über der ersten Antennenspule 51 liegt und teilweise außerhalb.

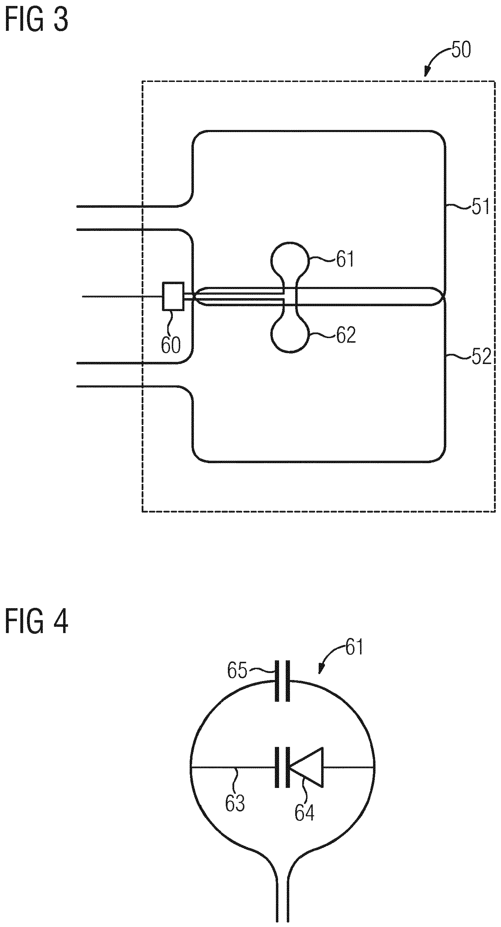

In Fig. 3 wird eine Ausführungsform der Lokalspule mit einer ersten Antennenspule 51 und einer zweiten Antennenspule 52 dargestellt. Die erste Antennenspule 51 und die zweite Antennenspule 52 sind dabei nebeneinander angeordnet, um unabhängig voneinander unterschiedliche Bereiche des Patienten 100, unter Umständen sogar gleichzeitig, erfassen zu können. Dabei wird ein Signal der Nachbarspule als Störsignal angesehen. Auch führen die in den Raum der jeweils anderen Spule reichenden Magnetfelder auch zu Wechselwirkungen wie ein Verstimmen der Resonanzfrequenz der Antennenspulen. Es ist daher erwünscht, dass die erste Antennenspule 51 und die zweite Antennenspule 52 voneinander entkoppelt sind, in dem Sinne, dass die Wechselwirkungen reduziert werden. Wie bereits zu Fig. 2 anhand der ersten Antennenspule 51 und der Sendespule mit erster Induktionsschleife 61 und zweiter Induktionsschleife 62 erläutert, kann dies dadurch erreicht werden, dass umschlossene Flächen überlappen. In Fig. 3 ist daher zwischen der ersten Antennenspule 51 und der zweiten Antennenspule 52 eine Fläche zwischen der ersten Antennenspule 51 und der zweiten Antennenspule 52 vorgesehen, die von beiden Antennenspulen umschlossen wird bzw. in dem die beiden Antennenspulen überlappen. Bei geeigneter Wahl der von überlappenden Flächenbereichen zu nicht überlappenden Flächenbereichen kann eine völlige Entkopplung der ersten Antennenspule 51 von der zweiten Antennenspule 52 erzielt werden.

Eine Anordnung der ersten Induktionsschleife 61 oder zweiten Induktionsschleife 62 in diesem überlappenden Bereich der beiden Antennenspulen 51, 52 reduziert die Freiheitsgrade zur Entkopplung der Sendespule von den beiden Antennenspulen 51 und 52. Diese Freiheitsgrade können erst wieder gewonnen werden, indem die erste Induktionsschleife 61 und die zweite Induktionsschleife 62 durch Leiter verbunden sind, die eine möglichst geringe effektive Fläche begrenzen, beispielsweise indem diese Verbindungsleiter eng aneinander parallel geführt oder miteinander verdrillt sind. In der Fig. 3 ist das durch einen "knochenförmigen" Umriss von erster Induktionsschleife 61, zweiter Induktionsschleife 62 und den verbindenden Leiter dazwischen angedeutet. Indem die effektive Fläche der Verbindung von erster Induktionsschleife 61 und zweiter Induktionsschleife 62 für die Induktion durch die erste Antennenspule und/oder zweite Antennenspule gegen Null geht, kann die Länge der Verbindung variiert werden und damit der Abstand bzw. die Position bezüglich der ersten Antennenspule 51 und der zweiten Antennenspule 52 genutzt werden, um die Entkopplung der Sendespule von der den Antennenspulen 51, 52 gleichzeitig mit der gegenseitigen Entkopplung von erster Antennenspule 51 und zweiter Antennenspule 52 zu verbessern bzw. zu optimieren.

In Fig. 4 ist eine Möglichkeit dargestellt, wie sich die effektive Fläche der ersten Induktionsschleife 61 und/oder der zweiten Induktionsschleife 62 ohne mechanische Veränderung der Leiterschleife anpassen lässt. Fig. 4 zeigt beispielhaft die erste Induktionsschleife 61. Diese ist in der gezeigten Ausführungsform zum einen mit einer Ausgleichskapazität 65 versehen, um die Stromverteilung in der ersten Induktionsschleife 61 bzw. der Sendeantenne bestehend aus erster Induktionsschleife 61 und zweiter Induktionsschleife 62 zwischen den durch einen nachfolgend erläuterten Überbrückungsleiter 63 aufgeteilten Bereichen auszugleichen. Denkbar wären aber auch Kapazitäten zur Abstimmung einer Resonanz.

Zum anderen weist die erste Induktionsschleife 62 auch zwei Anzapfungen bzw. Kontaktstellen entlang des Schleifenleiters auf, die durch den Überbrückungsleiter 63 elektrisch miteinander verbunden sind. Der Überbrückungsleiter 63 teilt dabei die von der ersten Induktionsschleife umschlossene Fläche in zwei disjunkte Teilbereiche. Das Flächenverhältnis der Teilbereiche kann beispielsweise 50:50 sein, aber auch 40:60 oder kleiner. Der Überbrückungsleiter 63 kann dabei eine oder mehrere Kapazitäten aufweisen, die in Serie in den Überbrückungsleiter geschaltet sind. Die Kapazität kann dabei einen konstanten Wert aufweisen und bei der Bestückung der Lokalspule 50 die Sendeantenne bzw. die erste Induktionsschleife 61 an unterschiedliche Geometrien anpassen, sodass die gleiche Leiterschleife für unterschiedliche Induktionsschleifen in unterschiedlichen Lokalspulen verwendet werden kann. Denkbar ist auch ein Trimmkondensator, der auch noch eine Anpassung bei der Installation erlaubt.

Schließlich ist es auch denkbar, dass die Kapazität als veränderbare Kapazität 64 ausgeführt ist, sodass diese ohne mechanischen Zugriff durch den Magnetresonanztomographen 1 verändert werden kann. Denkbar ist eine PIN-Diode als veränderbare Kapazität 64, bei der das Pilotton-Signal mit einer Gleichspannung als Steuerspannung durch die Steuereinheit 20 bzw. die Hochfrequenzeinheit 22 überlagert wird. Denkbar ist auch eine Steuerung in der Lokalspule 50, die auf ein Signal der Steuereinheit 20 des Magnetresonanztomographen eine Spannung an die PIN-Diode anlegt. Denkbar sind auch von der Steuerung der Lokalspule durch Schalter zuschaltbare Kapazitäten.

Indem der Magnetresonanztomograph 1 ausgelegt ist, über die veränderbare Kapazität 64 in dem Überbrückungsleiter 63 die effektive Fläche der ersten Induktionsschleife 61 und in einer nicht dargestellten Ausführungsform auch der zweiten Induktionsschleife 62 anzupassen, kann die Entkopplung auch an veränderte Verhältnisse, beispielsweise an andere Patienten automatisch angepasst werden und immer ein optimales Signal-zu-Rausch-Verhältnis für das Pilotton-Signal mit der erfindungsgemäßen Lokalspule erzielt werden.

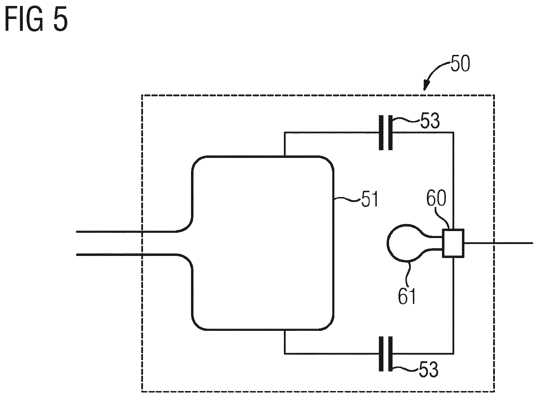

In Fig. 5 ist eine nicht beanspruchte Ausführungsform der Lokalspule 50 dargestellt, bei der die Entkopplung der ersten Antennenspule 51 von der ersten Induktionsschleife 61 durch eine kapazitive Entkopplung mittels eines Entkopplungsnetzwerkes erfolgt. Das Entkopplungsnetzwerk wird im einfachsten Fall durch zwei Entkopplungskapazitäten 53 bereitgestellt, die die erste Antennenspule 51 an unterschiedlichen Anzapfungen mit der ersten Induktionsschleife 61 verbinden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Lokalspule für einen Magnetresonanztomographen (1), wobei die Lokalspule (50) eine Sendeantenne zur Abstrahlung eines Pilottons und eine Empfangsantenne zum Empfang des Pilottons aufweist, wobei die Lokalspule weiterhin eine Entkopplungsvorrichtung zum Entkoppeln der Empfangsantenne von der Sendeantenne aufweist,
wobei die Entkopplungsvorrichtung ausgelegt ist, die Sendeantenne induktiv von der Empfangsantenne zu entkoppeln, wobei die Empfangsantenne eine erste Antennenspule (51) und die Entkopplungsvorrichtung eine erste Induktionsschleife (61) aufweist, wobei eine Projektion einer von der ersten Induktionsschleife (61) umschlossenen Fläche auf eine von der ersten Antennenspule (51) umschlossene Fläche entlang einer Flächennormale der umschlossenen Fläche eine nichtleere Schnittmenge aufweist,
**dadurch gekennzeichnet, dass**
die Entkopplungsvorrichtung eine zweite Induktionsschleife (62) aufweist, die im Wesentlichen parallel zur ersten Induktionsschleife (61) ausgerichtet ist,
wobei die Entkopplungsvorrichtung ausgelegt ist, bei Aussenden des Pilottons jeweils ein Magnetfeld in der ersten Induktionsschleife (61) und der zweiten Induktionsschleife (62) zu erzeugen, deren Magnetfeldkomponenten in Richtung der Flächennormalen der von der ersten Induktionsschleife (61) und/oder zweiten Induktionsschleife (62) umschlossenen Fläche gleiche Vorzeichen aufweisen, wobei eine Projektion der von der zweiten Induktionsschleife (62) umschlossenen Fläche auf eine von der ersten Antennenspule (51) umschlossene Fläche entlang einer Flächennormale der umschlossenen Fläche eine leere Schnittmenge aufweist, wobei die Sendeantenne die erste Induktionsschleife (61) und die zweite Induktionsschleife (62) aufweist.

2. Lokalspule nach Anspruch **1,** wobei die Lokalspule (50) einen Pilotton-Sender (60) zur Erzeugung des Pilottons aufweist.

3. Lokalspule nach Anspruch 1 oder **2,** wobei die Lokalspule (50) eine zweite Antennenspule (52) aufweist, wobei eine Projektion der von der ersten Induktionsschleife (61) umschlossenen Fläche auf eine von der zweiten Antennenspule (52) umschlossene Fläche entlang einer Flächennormale der umschlossenen Fläche eine leere Schnittmenge aufweist und wobei eine Projektion der von der zweiten Induktionsschleife (62) umschlossenen Fläche auf eine von der zweiten Antennenspule (52) umschlossene Fläche entlang einer Flächennormale der umschlossenen Fläche eine nichtleere Schnittmenge aufweist.

4. Lokalspule nach Anspruch 3, wobei eine Projektion der von der ersten Antennenspule (51) umschlossenen Fläche entlang der Flächennormale auf die von der zweiten Antennenspule (52) umschlossene Fläche eine nichtleere Schnittmenge aufweist.

5. Lokalspule nach einem der Ansprüche 1 bis 4, wobei die erste Induktionsschleife (61) einen Überbrückungsleiter (63) aufweist, der zwei Punkte der ersten Induktionsschleife (61) elektrisch miteinander verbindet und die von der ersten Induktionsschleife (61) umschlossene Fläche in zwei disjunkte Bereiche unterteilt.

6. Lokalspule nach Anspruch 5, wobei der Überbrückungsleiter (63) eine veränderbare Kapazität (64) aufweist.

7. Magnetresonanztomograph mit einer Lokalspule (50) nach Anspruch 1,
wobei der Magnetresonanztomograph (1) ausgelegt ist, ein Pilotton-Signal bereitzustellen, über eine Signalverbindung an die Lokalspule (50) zu übertragen und über die Sendeantenne der Lokalspule (50) auszusenden.

8. Magnetresonanztomograph mit einer Lokalspule (50) nach Anspruch 6, wobei die Steuereinheit (20) des Magnetresonanztomographen (1) ausgelegt ist, die veränderbare Kapazität (64) derart einzustellen, dass die Empfangsantenne von der Sendeantenne optimal entkoppelt ist.

## Claims

1. Local coil for a magnetic resonance tomography device (1), wherein the local coil (50) has a transmit antenna for radiating a pilot tone and a receive antenna for receiving the pilot tone, wherein the local coil further has a decoupling apparatus for decoupling the receive antenna from the transmit antenna,
wherein the decoupling apparatus is designed to decouple the transmit antenna inductively from the receive antenna, wherein the receive antenna has a first antenna coil (51) and the decoupling apparatus has a first induction loop (61), wherein a projection of a surface enclosed by the first induction loop (61) onto a surface enclosed by the first antenna coil (51) along a surface normal of the enclosed surface has a non-empty intersection,
**characterised in that**
the decoupling apparatus has a second induction loop (62), which is aligned essentially parallel to the first induction loop (61),
wherein the decoupling apparatus is designed to generate in each case a magnetic field in the first induction loop (61) and the second induction loop (62) when the pilot tone is emitted, the magnetic field components of which have the same signs in the direction of the surface normal of the surface enclosed by the first induction loop (61) and/or second induction loop (62),
wherein a projection of the surface enclosed by the second induction loop (61) onto a surface enclosed by the first antenna coil (51) along a surface normal of the enclosed surface has an empty intersection, wherein the transmit antenna has the first induction loop (61) and the second induction loop (62).

2. Local coil according to claim **1,** wherein the local coil (50) has a pilot tone transmitter (60) for generating the pilot tone.

3. Local coil according to claim 1 or 2, wherein the local coil (50) has a second antenna coil (52),
wherein a projection of the surface enclosed by the first induction loop (61) onto a surface enclosed by the second antenna coil (51) along a surface normal of the enclosed surface has an empty intersection and wherein a projection of the surface enclosed by the second induction loop (61) onto a surface enclosed by the second antenna coil (51) along a surface normal of the enclosed surface has a non-empty intersection.

4. Local coil according to claim 3, wherein a
projection of the surface enclosed by the first antenna coil (51) along the surface normal onto the surface enclosed by the second antenna coil (51) has a non-empty intersection.

5. Local coil according to one of claims 1 to 4, wherein the first induction loop (61) has a jumper conductor (63), which connects two points of the first induction loop (61) electrically with one another and which divides the surface enclosed by the first induction loop (61) into two disjunct regions.

6. Local coil according to claim 5, wherein the jumper conductor (63) has a changeable capacitance (64).

7. Magnetic resonance tomography device with a local coil (50) according to claim 1,
wherein the magnetic resonance tomography device (1) is designed to provide a pilot tone signal, to transmit the same via a signal connection to the local coil (50) and to emit the same via the transmit antenna of the local coil (50).

8. Magnetic resonance tomography device with a local coil (50) according to claim 6, wherein the control unit (20) of the magnetic resonance tomography device (1) is designed to adjust the changeable capacitance (64) in such a way that the receive antenna is decoupled optimally from the transmit antenna.

## Revendications

1. Bobine locale d'un tomodensitomètre (1) par résonance magnétique, dans laquelle la bobine (50) locale a une antenne d'émission pour l'émission d'une tonalité pilote et une antenne de réception pour la réception de la tonalité pilote, dans lequel la bobine locale a, en outre, un dispositif de découplage pour le découplage de l'antenne de réception de l'antenne d'émission,
dans laquelle le dispositif de découplage est conçu pour découpler par induction l'antenne d'émission de l'antenne de réception, dans laquelle l'antenne de réception a une première bobine (51) d'antenne et le dispositif de découplage une première boucle (61) d'induction, dans laquelle une projection d'une surface entourée par la première boucle (61) d'induction sur une surface entourée par la première bobine (51) d'antenne a, le long d'une surface normale à la surface entourée, une intersection non vide,
**caractérisée en ce que**
le dispositif de découplage a une deuxième boucle (62) d'induction, qui est sensiblement parallèle à la première boucle (61) d'induction,
dans lequel le dispositif de découplage est conçu pour produire, lors de l'émission de la tonalité pilote respectivement un champ magnétique dans la première boucle (61) d'induction et dans la deuxième boucle (62) d'induction, dont les composantes de champ magnétique ont les mêmes signes dans la direction des normales aux surfaces de la surface entourée par la première boucle (61) d'induction et/ou la deuxième boucle (62) d'induction,
dans laquelle une projection de la surface entourée par la deuxième boucle (62) d'induction sur une surface entourée par la première bobine (51) d'antenne a, le long d'une normale à la surface entourée, une intersection vide, dans laquelle l'antenne d'émission comporte la première boucle (61) d'induction et la deuxième boucle (62) d'induction.

2. Bobine locale suivant la revendication 1, dans laquelle la bobine (50) locale a un émetteur (60) de tonalité pilote pour la production de la tonalité pilote.

3. Bobine locale suivant la revendication 1 ou 2, dans laquelle la bobine (50) locale a une deuxième bobine (52) d'antenne, dans laquelle une projection de la surface entourée par la première boucle (61) d'induction sur une surface entourée par la deuxième bobine (52) d'antenne, le long d'une normale à la surface entourée, a une intersection vide et dans laquelle une projection de la surface entourée par la deuxième boucle (62) d'induction sur une surface entourée par la deuxième bobine (52) d'antenne, le long d'une normale à la surface entourée, a une intersection non vide.

4. Bobine locale suivant la revendication 3, dans laquelle une projection de la surface entourée par la première bobine (51) d'antenne, le long de la normale à la surface entourée par la deuxième bobine (52) d'antenne, a une intersection non vide.

5. Bobine locale suivant l'une des revendications 1 à 4, dans laquelle la première boucle (61) d'induction a un conducteur (63) de court-circuit, qui relie entre eux électriquement deux points de la première boucle (61) d'induction et qui subdivise en deux parties disjointes la surface entourée par la première boucle (61) d'induction.

6. Bobine locale suivant la revendication 5, dans laquelle le conducteur (63) de court-circuit a une capacité (64) variable.

7. Tomodensitomètre par résonance magnétique, comprenant une bobine (50) locale suivant la revendication 1,
dans lequel le tomodensitomètre (1) par résonance magnétique est conçu pour mettre à disposition un signal de tonalité pilote, le transmettre par une liaison de signal à la bobine (50) locale et l'émettre par l'antenne d'émission de la bobine (50) locale.

8. Tomodensitomètre par résonance magnétique, comprenant une bobine (50) suivant la revendication 6, dans lequel l'unité (20) de commande du tomodensitomètre (1) par résonance magnétique est conçue pour régler la capacité (64) variable, de manière à découpler au mieux l'antenne de réception de l'antenne d'émission.
